(19) Europäisches Patentamt
European Patent Office
Office européen des brevets

(11) **EP 3 940 864 B1**

(12) **EUROPÄISCHE PATENTSCHRIFT**

(45) Veröffentlichungstag und Bekanntmachung des Hinweises auf die Patenterteilung:
**05.10.2022 Patentblatt 2022/40**

(21) Anmeldenummer: **21183883.4**

(22) Anmeldetag: **06.07.2021**

(51) Internationale Patentklassifikation (IPC):
**H01M 10/42** *(2006.01)* **H01M 10/48** *(2006.01)*
**G01F 17/00** *(2006.01)*

(52) Gemeinsame Patentklassifikation (CPC):
**H01M 10/48; G01F 22/02; H01M 10/4285;**
Y02E 60/10

(54) **VERFAHREN UND VORRICHTUNG ZUR BESTIMMUNG DER MENGE EINES IN EINER BATTERIEZELLE BEFINDLICHEN GASES**

METHOD AND DEVICE FOR DETERMINING THE AMOUNT OF GAS IN A BATTERY CELL

PROCÉDÉ ET DISPOSITIF DE DÉTERMINATION DE LA QUANTITÉ D'UN GAZ SE TROUVANT DANS UN ÉLÉMENT DE BATTERIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **13.07.2020 DE 102020118436**

(43) Veröffentlichungstag der Anmeldung:
**19.01.2022 Patentblatt 2022/03**

(73) Patentinhaber: **VOLKSWAGEN AG**
**38440 Wolfsburg (DE)**

(72) Erfinder:
• **Rumberg, Björn**
**38300 Wolfenbüttel (DE)**
• **Epding, Bernd**
**38112 Braunschweig (DE)**

(74) Vertreter: **karo IP**
**karo IP Patentanwälte**
**Kahlhöfer Rößler Kreuels PartG mbB**
**Platz der Ideen 2**
**40476 Düsseldorf (DE)**

(56) Entgegenhaltungen:
**CN-A- 101 281 984    KR-A- 20180 135 587**

**Beschreibung**

Die vorliegende Erfindung betrifft ein Verfahren und eine Vorrichtung zur Bestimmung der Menge eines in einer Batteriezelle befindlichen Gases.

Batteriezellen, wie sie beispielsweise in den Traktionsbatterien von Elektrofahrzeugen zu Anwendung kommen, weisen in der Regel eine Mehrzahl von sogenannten Pouchzellen auf. Die Pouchzellen sind dabei so aufgebaut, dass eine widerstandsfähige Pouchfolie verwendet wird, um einen darin angeordneten Zellstapel dauerhaft und dicht zu umschließen. Der Zellstapel weist dazu beispielsweise Anodenschichten, Kathodenschichten und Separatorschichten, einen Elektrolyten und Ableiterfähnchen auf, um die erzeugten Ströme über Ableitertabs zu den an einer Außenseite der Pouchzellen liegenden Kontakte zu leiten.

Für die Bestimmung der Langzeithaltbarkeit von Lithium-Ionen-Pouchzellen ist es notwendig, die Gasbildung und den damit verbundenen Druckanstieg in den Pouchzellen zu bestimmen. Mit den so gewonnenen Informationen können physikalische und empirische Modelle erstellt und mit Daten ausgestattet werden, die eine Vorhersage der Gasbildung unter unterschiedlichen Einsatzszenarien erlauben. Hierzu ist es beispielsweise bekannt, dass die Änderung des Volumens von Pouchzellen, welches sich durch ein Aufbeulen der Pouchzellen bzw. sogenannter Gas-Pockets äußert, zur Messung der Gasbildung verwendet wird. Hierzu ist es bekannt, das Archimedes-Prinzip zu verwenden, wie es beispielsweise in der US 2019/0280333A1 beschrieben ist. Der Nachteil dieser Methode besteht darin, dass sobald eine Pouchzellen vollständig mit Gas aufgefüllt ist, nur noch der Druck innerhalb der Pouchzelle ansteigt, sich das Volumen jedoch nicht mehr ändert. Somit kann mit dieser Methode lediglich die anfängliche, d. h. die initiale Gasbildung vermessen werden.

KR 2018 0135587 beschreibt ein Verfahren und eine Vorrichtung zur Bestimmung der Menge eines in einer Batteriezelle befindlichen Gases bei dem während der Ladung und Entladung Druck auf eine in eine Flüssigkeit getauchte Batteriezelle ausgeübt wird, während die Gewichtsänderung der Batterie gemessen wird. Daraus, und aus der Volumenänderung der Flüssigkeit, wird eine Volumenänderung der Batterie bestimmt.

Weiterhin ist es bekannt die in einer Pouchzelle befindliche Gasmenge zu bestimmen, indem die Pouchzelle in einem Vakuum eines definierten Volumens geöffnet wird, um anschließend aus dem dabei gemessenen Druckanstieg das Volumen der Gasmenge abzuleiten. Bei dieser zweiten Methode zur Bestimmung der in der Pouchzelle enthaltenen Gasmenge ist es erforderlich, die zu untersuchende Pouchzelle zum Zweck der Messung zu zerstören. Damit ist es aber nicht möglich, die Gasbildung in einer Pouchzelle über einen längeren Zeitraum zu beobachten. Stattdessen ist eine sehr große Anzahl zu testender Pouchzellen erforderlich, wenn ein Modell für die Gasbildung unter verschiedenen Ladungszuständen und Temperaturen erstellt werden soll. Außerdem tritt bei dieser Methode der Nachteil auf, dass die bestimmte Gasmenge in signifikanter Weise von der Lösungsfähigkeit des Gases im jeweils verwendeten Elektrolyten beeinflusst wird. Die Lösungsfähigkeit des Gases im Elektrolyten wiederum ist in erheblicher Weise vom vorliegenden Druck in der Batteriezelle bzw. Pouchzelle und von der Temperatur abhängig, sodass auch die zu ermittelnde Gasmenge in erheblichem Umfang von der zum Zeitpunkt der Bestimmung herrschenden Temperatur und dem dann vorliegenden Messdruck abhängig ist.

Aufgabe der vorliegenden Erfindung ist es daher, die sich aus dem Stand der Technik ergebenden Probleme zumindest teilweise zu lösen. Insbesondere sollen ein Verfahren und eine Vorrichtung angegeben werden, die eine verbesserte Bestimmung der in einer Batteriezelle enthaltenen Gasmengen ermöglicht. Insbesondere soll die Bestimmung der Gasmenge zerstörungsfrei erfolgen, um die Gasmengen durch wiederholte und über einen Zeitraum verteilt durchgeführte Messungen an einer Batteriezelle zerstörungsfrei und bei unterschiedlichen Temperaturen vornehmen zu können.

Zur Lösung dieser Aufgaben trägt ein Verfahren mit den Merkmalen gemäß Patentanspruch 1 bei. Vorteilhafte Weiterbildungen sind Gegenstand der abhängigen Patentansprüche. Die in den Patentansprüchen einzeln aufgeführten Merkmale sind in technologisch sinnvoller Weise miteinander kombinierbar und können durch erläuternde Sachverhalte aus der Beschreibung und/oder Details aus den Figuren ergänzt werden, wobei weitere Ausführungsvarianten der Erfindung aufgezeigt werden.

Vorliegend wird ein Verfahren zur Bestimmung der Menge eines in einer Batteriezelle befindlichen Gases vorgeschlagen, wobei die Batteriezelle ein Ausgangsvolumen hat, und das Verfahren wenigsten die folgenden Schritte aufweist:

a) Eintauchen der Batteriezelle in eine nichtleitende Flüssigkeit mit definierter Dichte unter einem ersten Umgebungsdruck;
b) Erzeugen einer Hebekraft, die einer Abtriebskraft der Batteriezelle entgegengerichtet ist;
c) Änderung des Umgebungsdrucks auf einen zweiten Umgebungsdruck und messen einer vom Umgebungsdruck abhängigen Auftriebskraft der Batteriezelle in der Flüssigkeit;
d) Ermitteln der Menge des in der Batteriezelle befindlichen Gases unter Berücksichtigung des zweiten Umgebungsdrucks, der für den zweiten Umgebungsdruck ermittelten Auftriebskraft, einer Temperatur der Flüssigkeit und der Dichte der Flüssigkeit.

Bei dem Verfahren wird in einem ersten Schritt a) die zu untersuchende Batteriezelle in eine nichtleitende Flüssigkeit eingetaucht. Dies geschieht, indem die Batteriezelle vollständig in die Flüssigkeit eingetaucht wird. Die Flüssigkeit selbst ist nichtleitend, d. h. sie kann keinen elektrischen Strom leiten, und weist zudem eine bekannte Dichte, die beispielsweise in Gramm pro Kubikzentimeter angegeben sein kann, auf.

Der erste Umgebungsdruck kann dabei beispielsweise der hydrostatische Luftdruck an dem Ort der Erdatmosphäre sein, an dem die Messung durchgeführt wird. Dieser Druck entsteht (veranschaulicht) durch die Gewichtskraft der Luftsäule, die auf der Erdoberfläche oder einem Körper steht. So beträgt etwa der mittlere Luftdruck der Atmosphäre auf Meereshöhe normgemäß 101325 [Pa]. Der erste Umgebungsdruck kann aber auch der tatsächlich am Messort herrschende Luftdruck sein oder ein genormter Luftdruck, wenn eine besonders gute Vergleichbarkeit und Reproduktion verschiedener Messungen erreicht werden soll, die alle unter gleichem Luftdruck durchgeführt worden sind. In diesem Fall kann beispielsweise der mittlere Luftdruck der Atmosphäre von 101325 [Pa] sein. Insbesondere für die Ermittlung der Gasmenge bei vollständig gefüllten Batteriezellen, die bereits ihr maximales Volumen erreicht haben, ist es sinnvoll bereits den ersten Umgebungsdruck so zu wählen, dass dieser größer ist als der Druck des in der Batteriezelle befindlichen Gases.

Im nächsten Schritt b) wird eine Hebekraft erzeugt, die einer von der Batteriezelle erzeugten Abtriebskraft entgegen gerichtet ist. Die Hebekraft diente dazu die Batteriezellen in der Flüssigkeit in einem schwebenden Zustand zu halten.

In dem nachfolgenden Schritt c) wird der Umgebungsdruck, welcher in dem die Flüssigkeit und die Batteriezellen umgebenden Medium herrscht, auf einen zweiten Umgebungsdruck erhöht. Während der Erhöhung des Umgebungsdrucks auf den zweiten Umgebungsdruck wird mittels einer Einzelmessung oder alternativ auch fortlaufend eine aus der Hebekraft und der Abtriebskraft resultierende Auftriebskraft der Batteriezelle gemessen.

Im vierten Schritt d) des Verfahrens wird dann die Menge des in der Batteriezelle befindlichen Gases ermittelt, wobei der erste und zweite Umgebungsdruck, die für diese Umgebungsdrücke ermittelten Auftriebskräfte, eine Temperatur der nichtleitenden Flüssigkeit und die Dichte der Flüssigkeit verwendet werden.

Hierbei wird zunächst davon ausgegangen, dass sich die Auftriebskraft basierend auf der allgemeinen Gasgleichung gemäß der nachfolgenden Formel berechnet:

$$m_{Auftrieb} = n \times R \times T \times \frac{1}{p} \times \rho_{Flüssigkeit} + (V_{Batteriezelle} + V_{Aufnahmevorricht.}) \times \rho_{Flüssigkeit}$$

Dabei können u.a. folgende Parameter ermittelt bzw. verwendet werden:

$m$ = Kraft [$N$]; z.B. $m_{Auftriebskraft}$; $m_{Abtriebskraft}$ ; $m_{Hebekraft}$; $m_{Messung}$
$n$ = Stoffmenge [$Mol$] des in der Batteriezelle befindlichen Gases

$R$ = universelle Gaskonstante; $[8{,}3144 \frac{Joule}{Kelvin \times Mol}]$

$T$ = Temperatur in Kelvin [$K$] p= Umgebungsdruck [$Pa$]
V= Volumen der Batteriezellen im Neuzustand; Volumen der Aufnahmevorrichtung

$\rho_{Flüssigkeit}$ = spezifische Dichte der nichtleitenden Flüssigkeit [ $\frac{Gramm}{cm^3}$ ]

Eine Aufnahmevorrichtung kann dazu genutzt werden, die Batteriezelle während des Tauchens in einer definierten und stabilen Lage zu fixieren. Bei Batteriezellen, die als sogenannte Pouchzellen aufgebaut sind, kann es dazu kommen, dass diese sich beim Eintauchen bereits durch ihr Eigengewicht verformen. Hierbei kann die Aufnahmevorrichtung Abhilfe schaffen und ein Eintauchen der Batteriezellen ohne größere Verformungen sicherstellen. Von den Verformungen ausgenommen sind dabei solche Verformungen, die durch eine Volumenänderung des in der Batteriezelle enthaltenen Gases hervorgerufen werden. Derartige Verformungen sind auch bei der Verwendung der Aufnahmevorrichtungen noch möglich. Insbesondere sind dabei Verformungen von Gastaschen möglich, sofern diese an der Batteriezelle vorgesehen sind und sich mit Gas füllen. Die Aufnahmevorrichtung sorgt beim Betrieb der Zelle zudem für Formstabilität und reproduzierbare elektrische Kenngrößen. Andernfalls könnten Gasbildung und Volumenarbeit der Aktivmaterialien zu einem Kontaktverlust der Elektrodenblätter in der Zelle führen.

Die Erfassung und bei Bedarf auch fortlaufende Überwachung der Temperatur der nichtleitenden Flüssigkeit kann beispielsweise durch einfache Temperatursensoren erfolgen.

Die zur Bestimmung der Gasmenge noch benötigte Auftriebskraft kann im Schritt d) des Verfahrens gemäß der folgenden Formel ermittelt werden:

$$m_{Auftriebskraft} = m_{Abtriebskraft} - m_{Hebekraft} + m_{Messung}$$

Die Abtriebskraft setzt sich hierbei zusammen aus der Gewichtskraft der Batteriezelle zuzüglich gegebenenfalls der Gewichtskraft der Haltevorrichtung zur Aufnahme der Batteriezelle in der Flüssigkeit.

Die Hebekraft ist dabei die von einer Krafterzeugungseinrichtung erzeugte Kraft, die der Abtriebskraft entgegengerichtet ist.

Ferner ist die gemessene resultierende Kraft [$m_{Messung}$] die aus der Abtriebskraft und der Hebekraft resultierende gemessene Kraft. Diese resultierende Kraft ist die von der Krafterzeugungseinrichtung nach Subtraktion der entgegenwirkenden Abtriebskraft ausgeübte Kraft.

Besonders vorteilhaft ist es dabei, wenn die Krafterzeugungseinrichtung gegen eine Kraftmesseinrichtung wirkt. In diesem Fall kann die resultierende Kraft unmittelbar als Messwerte aus der Kraftmesseinrichtung ausgelesen werden. Bei einer besonders einfachen Ausführungsform kann die Krafterzeugungseinrichtung ein definiertes Gewicht, eine vorgespannte Feder, ein Hydraulik- oder Pneumatikzylinder oder etwas Vergleichbares sein, dass dazu geeignet ist, eine Kraft auszuüben. Die Kraftmesseinrichtung kann beispielsweise eine Waage sein, welche die darauf einwirkende resultierende Kraft erfasst.

Liegen nach der Ausführung der genannten Schritte alle erforderlichen Angaben vor, kann die Stoffmenge (n) des in der Batteriezelle befindlichen Gases mittels der vorstehenden Gleichung nach Umformung berechnet werden.

Die Schritte a) bis d) können dazu wenigstens einmal in der hier angegebenen Reichenfolge) durchgeführt werden. Es ist möglich, dass diese Schritte unterschiedlich oft und/oder zumindest teilweise zeitlich überlagernd durchgeführt werden.

Auch kann der Schritt c) während der Erhöhung des Umgebungsdrucks mehrfach ausgeführt werden, so dass ein zeitlicher Verlauf der Auftriebskraft in Abhängigkeit von dem jeweiligen Umgebungsdruck ermittelt und aufgezeichnet wird.

Alternativ zu dieser Methode kann die Menge des in der Batteriezelle befindlichen Gases auch in der Weise bestimmt werden, dass das sich mit steigendem Umgebungsdruck verändernde Produkt aus

$$m_{Auftrieb} \times \frac{1}{R \times T} \times \frac{1}{\rho_{Flüssigkeit}}$$ ermittelt und aufgezeichnet wird, um daraus beispielsweise mittels eines grafischen Verfahrens oder einer mathematischen Funktion einen Graphen abzuleiten. Hierzu kann das Produkt beispielsweise auf einer Y-Achse und der reziproke Wert des Umgebungsdrucks auf einer X-Achse eines zweidimensionalen Koordinatensystems aufgetragen werden. Die Stoffmenge des in der Batteriezelle befindlichen Gases ergibt sich dabei unmittelbar aus der Steigung des Graphen in dem Wertebereich in denen eine Veränderung des Umgebungsdrucks zu einer Veränderung des Werts des Produktes führt. Konkret bedeutet dies, dass der Wert des Produktes konstant bleibt, solange der Umgebungsdruck kleiner oder gleich einem Gasinnendruck innerhalb der Batteriezelle ist. Der Gasinnendruck ist dabei der Gasdruck, der in dem innerhalb der Batteriezelle bzw. der Gastaschen befindlichen Gas herrscht. Sobald der Umgebungsdruck über den Gasinnendruck der Batteriezelle ansteigt, verändert sich das Volumen des Gases bzw. der Gastaschen und der Wert des Produktes beginnt sich mit zunehmendem Umgebungsdruck zu verkleinern. Dies ist dadurch zu erklären, dass das Gasvolumen aufgrund des steigenden Außendrucks komprimiert wird, wodurch die resultierende Auftriebskraft kleiner wird.

Insbesondere kann vorgesehen werden, dass bei der Ausführung des Verfahrens die nichtleitende Flüssigkeit und die Batteriezelle während der Schritte a) bis d) auf einer definierten Temperatur gehalten werden. Während das Verfahren problemlos bei unterschiedlichsten Temperaturen, wie beispielsweise unter Raumtemperatur, ausgeführt werden kann, ist es für den praktischen Betrieb von Batteriezellen häufig wünschenswert, deren Eigenschaften hinsichtlich der Bildung von Gasen bei höheren Temperaturen genauer zu untersuchen und zu bestimmen. Insbesondere höhere Temperaturen, wie beispielsweise Temperaturen, die zwischen 40 und 70 °C liegen, sind dabei von Interesse. Derartige Temperaturen können beispielsweise beim Betrieb von Batteriezellen in sehr heißen Umgebungen bzw. unter sommerlichen Betriebsbedingungen oder bei Schnellladevorgängen auftreten. Hier ist es besonders wichtig, das Verhalten der Batteriezellen bezüglich der Bildung von Gasen genauer zu kennen, um einen dauerhaft sicheren und zuverlässigen Betrieb der Batteriezellen zu gewährleisten.

Insbesondere kann bei dem Verfahren ferner vorgesehen werden, dass als zweiter Umgebungsdruck ein Druck gewählt wird, der höher ist als der Gasinnendruck in der Batteriezelle. Hierdurch kann die Bestimmung der in der Batteriezelle befindlichen Gasmenge auch bei Batteriezellen durchgeführt werden, die bereits in nennenswertem Umfang Gase gebildet haben und in denen sich bereits ein sehr hoher Gasinnendruck gegenüber dem Umgebungsdruck aufgebaut hat. Während bei bisher bekannten Verfahren die Bestimmung der in der Batteriezellen vorhandenen Gasmenge in diesem Zustand nicht mehr oder zumindest nicht zerstörungsfrei möglich war, kann durch die Verwendung eines zweiten Umgebungsdrucks, der höher ist als der in der Batteriezelle herrschende Gasinnendruck, auch in diesen Fällen eine zerstörungsfreie Bestimmung der enthaltenen Stoffmenge bzw. Gasmenge durchgeführt werden.

Insbesondere kann als zweiter Umgebungsdruck ein Druck gewählt werden, der niedriger ist als ein Gasinnendruck in der Batteriezelle. Dieses Verfahren kann angewendet werden, wenn die Batteriezelle ein nur sehr geringes Füllvolumen aufweist, bei dem das in der Batteriezelle befindliche Gas unter einem nur sehr geringen Druck steht. In diesem Fall kann durch den reduzierten zweiten Druck das in der Batteriezelle vorhandene Gasvolumen zunächst vergrößert werden, wodurch die Ermittlung der Auftriebskraft erleichtert und präzisiert wird. Bei Bedarf kann der zweite Umgebungsdruck soweit reduziert werden, bis die Batteriezelle aufgrund des sich vergrößernden Gasvolumens ihre maximal mögliche Volumenausdehung erreicht. Durch die Verwendung des zweiten Umgebungsdrucks, der niedriger als der erste Umgebungsdruck ist, kann auch bei Batteriezellen eine Bestimmung der darin eingeschlossenen Gasmengen erfolgen bei denen das Gas unter einem nur sehr geringen Druck steht und die insbesondere ihre maximale Volumenausdehnung noch nicht erreicht haben.

Insbesondere kann bei der Ausführung des Verfahrens ferner vorgesehen werden, dass die Hebekraft so gewählt wird, dass diese zusammen mit der Auftriebskraft größer oder gleich der Abtriebskraft der Batteriezelle ist. Hierdurch wird erreicht, dass die in die nichtleitende Flüssigkeit eingetauchte Batteriezelle und gegebenenfalls auch die damit verbundene Aufnahmevorrichtung vollständig in die Flüssigkeit eintauchen, darin sicher in der Schwebe gehalten werden und gleichzeitig nicht auf den Grund des Flüssigkeitsbehälters absinken.

Insbesondere vorteilhaft ist es auch, wenn bei Schritt d) zusätzlich die temperaturabhängige Lösungsfähigkeit des Gases in einer in der Batteriezelle vorhandenen Flüssigkeit berücksichtigt wird. Es hat sich gezeigt, dass die Lösungsfähigkeit der in der Batteriezelle befindlichen Flüssigkeit zur Lösung des ebenfalls in der Batteriezelle befindlichen Gases mit steigender Temperatur erheblich abnehmen kann. Die Flüssigkeit ist in der Regel ein Elektrolyt und ggf. Feuchtigkeit, die sich in der Batteriezelle gebildet bzw. angesammelt hat. Ist dies der Fall, würde eine Nichtberücksichtigung der mit steigender Temperatur stark sinkenden Lösungsfähigkeit zu deutlichen Ungenauigkeiten bei der Bestimmung der Menge des freigesetzten Gases führen. Berücksichtigt man nun unter Kenntnis der tatsächlich bei der Messung vorhandenen Temperatur die Lösungsfähigkeit der Flüssigkeit, so kann die Stoffmenge mit deutlich verbesserter Genauigkeit ermittelt werden.

Insbesondere kann eine Messung der Parameter während der Schritte a), b) und c) in einer geschlossenen Druckkammer durchgeführt werden. Innerhalb einer geschlossenen Druckkammer kann der Umgebungsdruck besonders genau kontrolliert eingestellt werden. Dies hat zwei Vorteile. Zum einen können in besonders einfacher Weise auch höhere zweite Umgebungsdrücke realisiert werden, die deutlich über dem in der Batteriezelle herrschenden Gasinnendruck liegen. Wie bereits zuvor erwähnt können damit erstmals auch Batteriezellen mit besonders hohen Gasinnendrücken zur Bestimmung der darin vorhandenen Gasmenge untersucht werden. Hierbei ist es sogar möglich, den ersten Umgebungsdruck vor dem Beginn der Messungen zunächst abzusenken, um gegebenenfalls vorhandene und nur sehr kleine Gasvolumen zunächst zu vergrößern. Bei einer nachfolgenden Erhöhung des Umgebungsdrucks könnten dann auch die Volumenänderungen dieser sehr kleinen Gasvolumen erfasst, die zugehörigen Auftriebswert bestimmt und schließlich die Stoffmengen des Gases bestimmt werden. Schließlich kann innerhalb einer definierten Druckkammer die Messung des jeweils anliegenden Umgebungsdrucks mit besonders hoher Präzision durchgeführt werden, wodurch folglich auch die Berechnung der Menge des enthaltenen Gases mit hoher Präzision möglich wird. Zudem können Messungen hierdurch besonders gut reproduziert werden.

Insbesondere kann für die Ermittlung der Stoffmenge zumindest ein zeitlicher Druckverlauf des Umgebungsdrucks, ein Temperaturverlauf der nichtleitenden Flüssigkeit oder ein Verlauf der Auftriebskraft fortlaufend erfasst werden. Vorzugsweise werden die genannten Verläufe gleichzeitig und während des Anstiegs des Umgebungsdruck auf den zweiten Umgebungsdruck erfasst und gespeichert, um anschließend zwecks Bestimmung der Stoffmenge des Gases ausgewertet zu werden.

Das Verfahren ist insbesondere dazu geeignet, im Zusammenhang mit einer gealterten Batteriezelle ausgeführt zu werden, deren Gastaschen, auch Gas-Pockets genannt, ausgebeult sind und in denen der Gasinnendruck größer als ein hydrostatischer Luftdruck und insbesondere größer als 1 bar ist.

Ferner wird von der vorliegenden Erfindung eine Vorrichtung zur Bestimmung der Menge eines in einer Batteriezelle befindlichen Gases mit jeweils wenigstens einer Druckkammer, einem in der Druckkammer angeordneten Flüssigkeitsbehälter, einer Druckmesseinrichtung zur Messung eines Umgebungsdrucks, einer Vorrichtung zur Erzeugung einer Hebekraft, einer Messeinrichtung zur Messung einer resultierenden Auftriebskraft, sowie einer Steuerungsvorrichtung zur Erfassung und Verarbeitung der erfassten Messwerte und zur Ermittlung der Menge des Gases vorgeschlagen.

Der Umgebungsdruck wird dabei innerhalb der Druckkammer und in der direkten Umgebung der zu untersuchenden Batteriezelle gemessen. Die Druckmesseinrichtung ist dazu geeignet einen ersten Umgebungsdruck und auch eine Vielzahl weiterer höherer zweiter Umgebungsdrücke zu messen.

Hierbei kann die Steuerungseinrichtung mit mindestens einer Messeinrichtung, einem Sensor oder anderen Mitteln funktional verbunden sein, die geeignet bzw. eingerichtet sind, die hier beschriebenen Schritte des vorgeschlagenen Verfahrens, insbesondere gemäß der Schritte a) bis d) der Verfahrensansprüche, auszuführen.

Weiterhin kann die Vorrichtung eine Heizvorrichtung zur Beheizung der im Flüssigkeitsbehälter befindlichen nichtleitenden Flüssigkeit und eine Temperaturmesseinrichtung zur Messung einer Flüssigkeitstemperatur der Flüssigkeit aufweisen.

Ferner wird ein Computerprogramm vorgeschlagen, welches Befehle umfasst, die bewirken, dass die vorgeschlagene Vorrichtung die Verfahrensschritte gemäß dem unabhängigen Verfahrensanspruch ausführt.

Schließlich wird auch ein computerlesbares Medium vorgeschlagen, auf dem das Computerprogramm gespeichert ist.

Vorsorglich sei angemerkt, dass die hier verwendeten Zahlwörter ("erste", "zweite", ...) vorrangig (nur) zur Unterscheidung von mehreren gleichartigen Gegenständen, Größen oder Prozessen dienen, also insbesondere keine Abhängigkeit und/oder Reihenfolge dieser Gegenstände, Größen oder Prozesse zueinander zwingend vorgeben. Sollte eine Abhängigkeit und/oder Reihenfolge erforderlich sein, ist dies hier explizit angegeben oder es ergibt sich offensichtlich für den Fachmann beim Studium der konkret beschriebenen Ausgestaltung.

Die Erfindung sowie das technische Umfeld werden nachfolgend anhand der beiliegenden Figuren näher erläutert. Es ist darauf hinzuweisen, dass die Erfindung durch die angeführten Ausführungsbeispiele nicht beschränkt werden soll. Insbesondere ist es, soweit nicht explizit anders dargestellt, auch möglich, Teilaspekte der in den Figuren erläuterten Sachverhalte zu extrahieren und mit anderen Bestandteilen und Erkenntnissen aus der vorliegenden Beschreibung zu kombinieren. Insbesondere ist darauf hinzuweisen, dass die Figuren und insbesondere die dargestellten Größenverhältnisse nur schematisch sind. Es zeigen:

Fig.1: eine schematische Darstellung einer Vorrichtung zur Bestimmung eine Gasmenge in einer Batteriezelle; und

Fig. 2: ein im Rahmen des Verfahrens erstelltes Diagramm zur Bestimmung der Gasmenge.

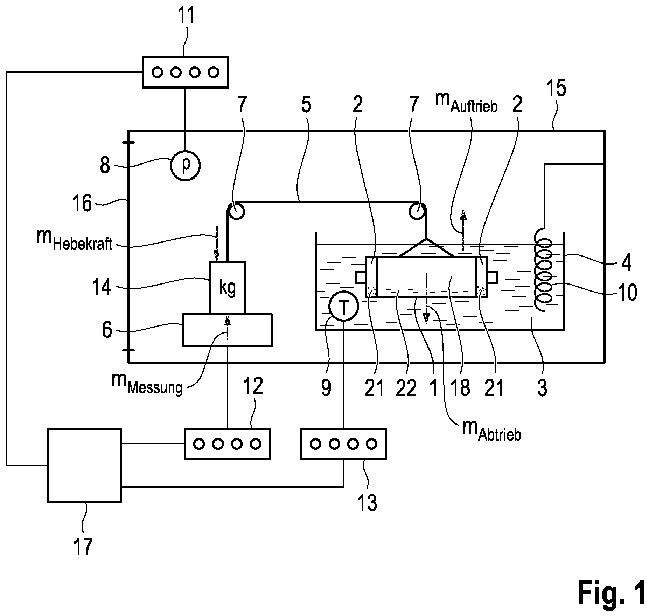

In Figur 1 ist eine mögliche Ausführungsform einer Vorrichtung zur Durchführung des erfindungsgemäßen Verfahrens zur Bestimmung einer Gasmenge eines Gases 21 in einer Batteriezelle 1 in einer schematischen Seitenansicht dargestellt. Die Batteriezelle 1 weist an zwei Enden Gastaschen 2 auf, die zur Aufnahme von Gas 21 bestimmt sind, welches sich innerhalb der Batteriezelle 1 im laufenden Betrieb bilden kann. Die Batteriezelle 1 ist vollständig in eine nichtleitende Flüssigkeit 3 eingetaucht, die in einem Flüssigkeitsbehälter 4 vorgehalten wird. Die Batteriezelle 1 wird von einer nach unten wirkenden Abtriebskraft [$m_{Abtrieb}$] unterhalb einer Oberfläche der nichtleitenden Flüssigkeit 3 gehalten. Der Abtriebskraft wirkt eine Hebekraft [$m_{Hebekraft}$] entgegen, die von einer Krafterzeugungseinrichtung 14 erzeugt wird. Die erzeugte Hebekraft wird dazu über ein Seil 5, welches über zwei Rollen 7 umgelenkt wird, an die Batteriezelle 1 weitergeleitet. Die Hebekraft ist dabei so bemessen, dass sie größer ist als die Abtriebskraft. Hierdurch wird die Batteriezelle 1 sicher in einem schwebenden Zustand innerhalb des Flüssigkeitsbehälters 4 gehalten. Die resultierende Kraft [$m_{Messung}$] aus der Hebekraft und der Abtriebskraft wirkt in vertikaler Richtung nach unten auf eine Kraftmesseinrichtung 6 ein. Die Kraftmesseinrichtung 6 ist dabei beispielsweise als Präzisionswaage ausgeführt und kann die resultierende Kraft sehr genau erfassen.

Die zuvor genannten Komponenten sind zusammen in einer Druckkammer 15 angeordnet. Weiterhin sind in der Druckkammer 15 eine Druckmesseinrichtung 8 und eine Temperaturmesseinrichtung 9 angeordnet. Sinkt eine Temperatur der nichtleitenden Flüssigkeit 3 unter einen vorgegebenen Temperaturwert ab, so kann die nichtleitende Flüssigkeit 3 mittels einer ebenfalls in der Druckkammer 15 angeordneten Heizvorrichtung 10 aufgeheizt und somit eine vorgegebene Temperatur gehalten werden. Die Druckkammer 15 weist ihrerseits eine Tür 16 auf, die dazu bestimmt ist, im geschlossenen Zustand die Druckkammer 15 vollständig gegenüber der Umgebung zu verschließen und im geöffneten Zustand einen Zugang zu den darin befindlichen Komponenten bzw. Vorrichtungen zu erlauben.

Die Druckmesseinrichtung 8 ist mit einer Anzeige- bzw. Aufzeichnungsvorrichtung für Druckmessungen 11 verbunden. Die Kraftmesseinrichtung 6 ihrerseits ist mit einer Anzeige- bzw. Aufzeichnungsvorrichtung für Kraftmessungen 12 verbunden und die Temperaturmesseinrichtung 9 ist mit einer Anzeige- bzw. Aufzeichnungsvorrichtung für Temperaturmessungen 13 verbunden. Alle Anzeige- bzw. Aufzeichnungsvorrichtungen 11, 12,13 sind mit einer Steuerungseinrichtung 17 verbunden, welche die gespeicherten Messdaten für Druck, Temperatur und der gemessenen Kraft abrufen und weiterverarbeiten kann. Um Verformungen der Batteriezelle 1 während der Messungen zu vermeiden, ist diese in einer Aufnahmevorrichtung 18 gehalten. Die Aufnahmevorrichtung 18 besteht bei der vorliegenden Ausführungsform aus zwei Spanplatten, zwischen denen die Batteriezelle 1 angeordnet ist, wobei die Spanplatten mittels einer Mehrzahl von Schrauben miteinander verbunden sind.

Bei der dargestellten Ausführungsform berechnet sich die Abtriebskraft somit aus der Gewichtskraft der Batteriezelle 1 und der Gewichtskraft der Aufnahmevorrichtung 18 einschließlich der verwendeten Spanplatten und Schrauben. Die Auftriebskraft, welche die Batteriezellen 1 und die Aufnahmevorrichtung 18 erfahren, bestimmt sich aus dem Volumen der beiden Komponenten und der spezifischen Dichte der nichtleitenden Flüssigkeit 3.

Da sich das Volumen der Batteriezelle 1 aufgrund der zu untersuchenden Gasbildung gegenüber dem bei der Herstellung definierten Ausgangsvolumen verändert hat, kann die Auftriebskraft nicht berechnet werden, sondern muss vielmehr durch Messungen ermittelt werden. Hierzu wird mittels der Kraftmesseinrichtung 6 die von der Krafterzeugungseinrichtung 14 auf diese ausgeübte resultierende Kraft gemessen. Die Krafterzeugungseinrichtung 14 ist bei dieser besonders einfachen Ausführungsform als definiertes Gewicht ausgebildet. Mit den so bekannten Werten lässt sich die Auftriebskraft m Auftrieb mit nachfolgender Formel berechnen:

$$m_{Auftriebskraft} = ( m_{Batteriezelle} + m_{Spanplatte} + m_{Schrauben} ) - m_{Hebekraft} + m_{Messung}$$

Eine erste Messung der Auftriebskraft erfolgt dabei unter einem ersten Umgebungsdruck 19, der beispielsweise dem normalen hydrostatischen Luftdruck am Messort entspricht. Danach wird der Umgebungsdruck 19 in der Druckkammer 15 schrittweise erhöht und für jeden eingestellten erhöhten Umgebungsdruck 19 jeweils die zugehörige Auftriebskraft bestimmt.

Die nachfolgende Formel beschreibt ihrerseits das Verhältnis der Auftriebskraft zur Stoffmenge des in der Batteriezelle 1 vorhandenen Gases 21. Mit den nun für verschiedene Umgebungsdrücke ermittelten Auftriebskräften kann durch Umformung der folgenden Gleichung die Stoffmenge des enthaltenen Gases 21 berechnet werden.

$$m_{Auftrieb} = n \times R \times T \times \frac{1}{p} \times \rho_{Flüssigkeit} + (V_{Zelle} + V_{Aufnahmevorrichtung}) \times \rho_{Flüssigkeit}$$

Diese Formel kann auch umgeformt werden zu

$$m_{Auftrieb} \cdot \frac{1}{R\,T\rho_{Flüssigkeit}} = n\frac{1}{p} + C$$

wobei für die Konstante C gilt: $$C = \frac{(V_{Zelle} + V_{Spannplatte})}{RT}$$ Hiermit lassen sich nun ein erster Auftrieb für den ersten Umgebungsdruck und ein zweiter Auftrieb für den zweiten Umgebungsdruck berechnen.

$$m_{Auftrieb,1} \cdot \frac{1}{R\,T\rho_{Flüssigkeit}} = n\frac{1}{p_1} + C$$

$$m_{Auftrieb,2} \cdot \frac{1}{R\,T\rho_{Flüssigkeit}} = n\frac{1}{p_2} + C$$

Berechnet man nun die Differenz aus dem ersten und zweiten Auftrieb, ist es möglich die Konstante C zu eliminieren und man erhält die Formel:

$$(m_{Auftrieb,1} - m_{Auftrieb,2}) \cdot \frac{1}{R\,T\rho_{Flüssigkeit}} = n(\frac{1}{p_1} - \frac{1}{p_2})$$

Diese kann dann zur Berechnung der Stoffmenge n wie folgt umgeformt werden.

$$\frac{(m_{Auftrieb,1} - m_{Auftrieb,2}) \cdot \dfrac{1}{R\,T\,\rho_{Flüssigkeit}}}{(\dfrac{1}{p_1} - \dfrac{1}{p_2})} = n$$

Somit kann die Stoffmenge n ermittelt werden, wobei zusätzlich zu den bekannten Werten R, T und $\rho_{Flüssigkeit}$ lediglich die Differenz der Auftriebskräfte und die Differenz der ersten und zweiten Umgebungsdrücke ermittelt werden müssen.

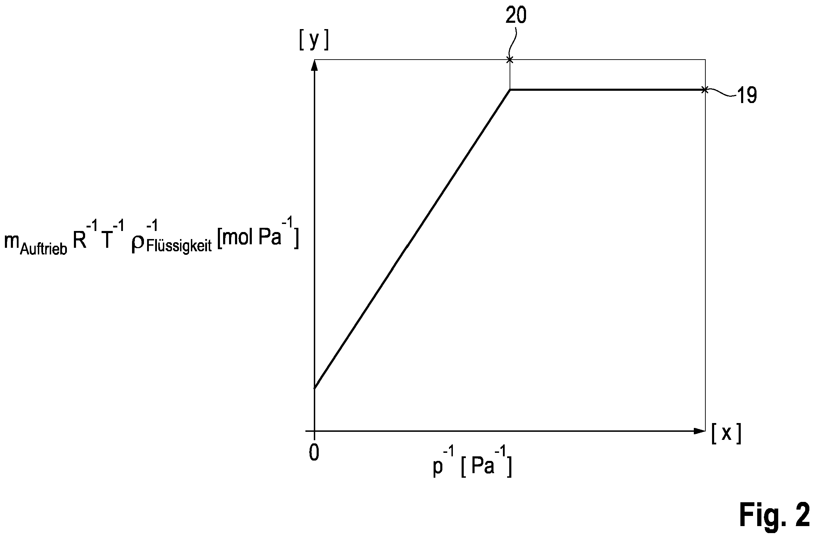

Wie in Figur 2 dargestellt, kann die Bestimmung der Stoffmenge alternativ auch mittels eines Graphen bzw. einer Funktion bestimmt werden.

Hierzu kann die Funktion

$$m_{Auftrieb} \times \frac{1}{R \times T} \times \frac{1}{\rho_{Flüssigkeit}}$$

in einem Koordinatensystem über dem reziproken Umgebungsdruck aufgetragen werden. Zu Beginn der Messung herrscht dabei ein erster Umgebungsdruck 19 und eine anfängliche Auftriebskraft. Mit zunehmendem Druck wandert der Graph zunächst nach links, bis der innerhalb der Druckkammer 15 eingestellte Umgebungsdruck 19 genauso groß ist wie der Gasinnendruck 20 innerhalb der Batteriezelle 1. Während des Druckanstiegs des Umgebungsdrucks vom ersten Umgebungsdruck 19 auf den Gasinnendruck 20 bleibt die Auftriebskraft zunächst konstant. Sobald der Umgebungsdruck auf einen Wert ansteigt, der größer als der Gasinnendruck 20 ist, beginnt die Auftriebskraft zu sinken.

Mit dem so gewonnenen Diagramm ergibt sich die Stoffmenge des innerhalb der Batteriezelle 1 befindlichen Gases 21 aus der Steigung der im linken Teil des Graphen dargestellten Kurve. In diesem Bereich des Graphen ist der Umgebungsdruck größer als der Gasinnendruck 20 in der Batteriezelle 1 bzw. in den Gastaschen 2.

Die hier beschriebene Methode bietet somit eine zerstörungsfreie Messung der Gasmenge in den Gastaschen 2 der Batteriezelle1. Die Methode kann selbst bei stark gealterten Batteriezellen, deren Gastaschen schon vollständig gefüllt und ausgebeult sind und die zudem einen stark erhöhten Gasinnendruck 20 aufweisen angewendet werden. Optional kann dabei auch die Temperaturabhängigkeit der Lösungsfähigkeit des Gases 21 in der Flüssigkeit 22, die sich in der Batteriezelle 1 befindet, berücksichtig werden. Die Flüssigkeit 22 kann beispielsweise der verwendete Elektrolyt, oder eine Mischung mit anderen ggf. anwesenden Flüssigkeiten sein. Dazu kann beispielsweise die nichtleitende Flüssigkeit 3 auf eine erhöhte Temperatur aufgeheizt werden, da die Lösungsfähigkeit der Flüssigkeit 22 bei höheren Temperaturen abnimmt. Hierbei ist davon auszugehen, dass eine Bestimmung der Stoffmenge des vorhandenen Gases 21 bei erhöhten Temperaturen grundsätzlich das kritischere Szenario darstellt. Bei höheren Temperaturen ist die Lösungsfähigkeit der Flüssigkeit 22 deutlich niedriger und es liegt relativ viel Gas 21 in gasförmiger Form vor. Dies ist beispielsweise bei einem Anwendungsfall gegeben, bei dem ein batterieelektrisches Fahrzeug sehr schnell geladen wird. Aus diesem Grund ist die Messung der gasförmigen Gasmenge zum Beispiel bei Temperaturen von 60 °C besonders wichtig.

Hierzu kann die Temperatur der nichtleitenden Flüssigkeit 3 optional über die Heizvorrichtung 10 angepasst werden.

## Bezugszeichenliste

1    Batteriezelle
2    Gastasche
3    nichtleitende Flüssigkeit
4    Flüssigkeitsbehälter
5    Seil
6    Kraftmesseinrichtung
7    Umlenkrolle
8    Druckmesseinrichtung
9    Temperaturmesseinrichtung
10   Heizvorrichtung

EP 3 940 864 B1

11 Anzeige oder Aufzeichnungsvorrichtung für Druckmessungen
12 Anzeige oder Aufzeichnungsvorrichtung für Kraftmessungen
13 Anzeige oder Aufzeichnungsvorrichtung für Temperaturmessungen
14 Krafterzeugungseinrichtung
15 Druckkammer
16 Tür
17 Steuerungseinrichtung
18 Aufnahmevorrichtung
19 erster, zweiter Umgebungsdruck
20 Gasinnendruck
21 Gas
22 Flüssigkeit in der Batteriezelle

**Patentansprüche**

1. Verfahren zur Bestimmung der Menge eines in einer Batteriezelle (1) befindlichen Gases (21), wobei die Batteriezelle (1) ein Ausgangsvolumen hat, und das Verfahren wenigstens die folgenden Schritte aufweist:

   a) Eintauchen der Batteriezelle (1) in eine nichtleitende Flüssigkeit (3) mit definierter Dichte unter einem ersten Umgebungsdruck (19);
   b) Erzeugen einer Hebekraft, die einer Abtriebskraft der Batteriezelle (1) entgegengerichtet ist;
   c) Änderung des Umgebungsdrucks auf einen zweiten Umgebungsdruck (19) und messen einer vom Umgebungsdruck (19) abhängigen Auftriebskraft der Batteriezelle (1) in der Flüssigkeit (3);
   d) Ermitteln der Menge des in der Batteriezelle (1) befindlichen Gases (21) unter Berücksichtigung des ersten und zweiten Umgebungsdrucks, der für diese Umgebungsdrücke ermittelten Auftriebskräfte, einer Temperatur der nichtleitenden Flüssigkeit (3) und der Dichte der Flüssigkeit.

2. Verfahren nach dem vorhergehenden Anspruch, wobei die nichtleitende Flüssigkeit (3) und die Batteriezelle (1) während der Schritte a) bis d) auf einer definierten Temperatur gehalten werden.

3. Verfahren nach einem der vorhergehenden Ansprüche, wobei als zweiter Umgebungsdruck ein Druck gewählt wird, der höher ist als ein Gasinnendruck (20) in der Batteriezelle (1).

4. Verfahren nach einem der vorhergehenden Ansprüche, wobei als zweiter Umgebungsdruck ein Druck gewählt wird, der niedriger ist als ein Gasinnendruck (20) in der Batteriezelle (1).

5. Verfahren nach einem der vorhergehenden Ansprüche, wobei die Hebekraft so gewählt wird, dass diese zusammen mit der Auftriebskraft größer oder gleich der Abtriebskraft der Batteriezelle (1) ist.

6. Verfahren nach einem der vorhergehenden Ansprüche, wobei bei Schritt d) zusätzlich die temperaturabhängige Lösungsfähigkeit des Gases (21) in einer in der Batteriezelle (1) vorhandenen Flüssigkeit (22) berücksichtigt wird.

7. Verfahren nach einem der vorhergehenden Ansprüche, wobei eine Messung der Parameter während der Schritte a), b) und c) in einer geschlossenen Druckkammer (15) durchgeführt wird.

8. Verfahren nach einem der vorhergehenden Ansprüche, wobei für die Ermittlung der Stoffmenge zumindest ein zeitlicher Druckverlauf des Umgebungsdrucks, ein Temperaturverlauf der nichtleitenden Flüssigkeit (3) oder ein Verlauf der Auftriebskraft fortlaufend erfasst wird.

9. Verfahren nach einem der vorhergehenden Ansprüche, wobei die Batteriezelle (1) eine gealterte Zelle aufweist, deren Gastaschen (2) ausgebeult sind und in denen der Gasinnendruck (20) größer als ein hydrostatischer Luftdruck und insbesondere größer als 1 bar ist.

10. Vorrichtung zur Bestimmung der Menge eines in einer Batteriezelle (1) befindlichen Gases (21) mit jeweils wenigstens einer Druckkammer (15), einem in der Druckkammer (15) angeordnetem Flüssigkeitsbehälter (4), einer Druckmesseinrichtung (8) zur Messung eines Umgebungsdrucks (19), einer Krafterzeugungseinrichtung (14) zur Erzeugung einer Hebekraft, einer Kraftmesseinrichtung (6) zur Messung einer resultierenden Auftriebskraft, sowie einer Steuerungsvorrichtung (17) zur Erfassung und Verarbeitung der erfassten Messwerte und zur Ermittlung der Menge des Gases (21).

11. Vorrichtung nach dem vorhergehenden Anspruch, **dadurch gekennzeichnet, dass** diese eine Heizvorrichtung (10) zur Beheizung der im Flüssigkeitsbehälter (4) befindlichen nichtleitenden Flüssigkeit (3) und eine Temperaturmesseinrichtung (9) zur Messung einer Flüssigkeitstemperatur der nichtleitenden Flüssigkeit (3) aufweist.

12. Computerprogramm, umfassend Befehle, die bewirken, dass die Vorrichtung nach Anspruch 10 die Verfahrensschritte gemäß Anspruch 1 ausführt.

13. Computerlesbares Medium auf dem das Computerprogramm nach Anspruch 11 gespeichert ist.

**Claims**

1. Method for determining the amount of a gas (21) present in a battery cell (1), whereby the battery cell (1) has an initial volume, and the method comprises at least the following steps:

   a) immersing the battery cell (1) in a non-conductive liquid (3) of defined density at a first ambient pressure (19);
   b) generating a lifting force that acts in the opposite direction of a downforce of the battery cell (1);
   c) changing the ambient pressure to a second ambient pressure (19) and measuring a buoyancy force of the battery cell (1) in the liquid (3) which is dependent on the ambient pressure (19);
   d) determining the amount of gas (21) present in the battery cell (1) taking into account the first and second ambient pressures, the buoyancy forces determined for these ambient pressures, a temperature of the non-conductive liquid (3) and the density of the liquid.

2. Method according to the preceding claim, wherein the non-conductive liquid (3) and the battery cell (1) are kept at a defined temperature during steps a) to d).

3. Method according to any one of the preceding claims, wherein a pressure selected as a second ambient pressure is higher than an internal gas pressure (20) in the battery cell (1).

4. Method according to any one of the preceding claims, wherein a pressure selected as the second ambient pressure is lower than an internal gas pressure (20) in the battery cell (1).

5. Method according to any one of the preceding claims, wherein the lifting force is selected to be, together with the buoyancy force, greater than or equal to the downforce of the battery cell (1).

6. Method according to any one of the preceding claims, wherein in step d) the temperature-dependent solubility of the gas (21) in a liquid (22) present in the battery cell (1) is additionally taken into account.

7. Method according to any one of the preceding claims, wherein a measurement of the parameters during steps a), b) and c) is performed in a closed pressure chamber (15).

8. Method according to one of the preceding claims, wherein for the determination of the amount of substance at least a pressure curve over time of the ambient pressure, a temperature curve of the non-conductive liquid (3) or a curve of the buoyancy force is continuously recorded.

9. Method according to one of the preceding claims, wherein the battery cell (1) comprises an aged cell, the gas pockets (2) of which are bulged and in which the internal gas pressure (20) is greater than a hydrostatic air pressure and in particular greater than 1 bar.

10. Device for determining the quantity of a gas (21) present in a battery cell (1), having in each case at least one pressure chamber (15), a liquid container (4) arranged in the pressure chamber (15), a pressure-measuring device (8) for measuring an ambient pressure (19), a force-generating device (14) for generating a lifting force, a force-measuring device (6) for measuring a resulting buoyancy force, and a control device (17) for recording and processing the recorded measured values and for determining the quantity of the gas (21).

**11.** Device according to the preceding claim, **characterized in that** it comprises a heating device (10) for heating the non-conductive liquid (3) located in the liquid container (4) and a temperature measuring device (9) for measuring a liquid temperature of the non-conductive liquid (3).

**12.** Computer program comprising instructions causing the device according to claim 10 to perform the method steps according to claim 1.

**13.** Computer-readable medium on which the computer program according to claim 11 is stored.

**Revendications**

**1.** Procédé de détermination de la quantité d'un gaz (21) se trouvant dans un élément de batterie (1), dans lequel l'élément de batterie (1) présente un volume de sortie et le procédé comporte au moins les étapes suivantes :

a) immersion de l'élément de batterie (1) dans un fluide non conducteur (3) avec une densité définie sous une première pression environnante (19) ;
b) génération d'une force de levage, qui est opposée à une force de portance de l'élément de batterie (1) ;
c) modification de la pression environnante à une deuxième pression environnante (19) et mesure d'une force de flottaison dépendant de la pression environnante (19) de l'élément de batterie (1) dans le fluide (3) ;
d) détermination de la quantité de gaz (21) se trouvant dans l'élément de batterie (1) en tenant compte des première et deuxième pressions environnantes, des forces de flottaison déterminées pour ces pressions environnantes, d'une température du fluide non conducteur (3) et de la densité du fluide.

**2.** Procédé selon la revendication précédente, dans lequel le fluide non conducteur (3) et l'élément de batterie (1) sont maintenus à une température définie pendant les étapes a) à d).

**3.** Procédé selon l'une quelconque des revendications précédentes, dans lequel, en guise de deuxième pression environnante, une pression est sélectionnée, qui est supérieure à une pression interne de gaz (20) dans l'élément de batterie (1).

**4.** Procédé selon l'une quelconque des revendications précédentes, dans lequel, en guise de deuxième pression environnante, une pression est sélectionnée, qui est inférieure à une pression interne de gaz (20) dans l'élément de batterie (1).

**5.** Procédé selon l'une quelconque des revendications précédentes, dans lequel la force de levage est sélectionnée de sorte que, conjointement avec la force de flottaison, elles soient supérieures ou égales à la force de portance de l'élément de batterie (1).

**6.** Procédé selon l'une quelconque des revendications précédentes, dans lequel, lors de l'étape d), en outre, l'aptitude à la dissolution dépendant de la température du gaz (21) est prise en compte dans un fluide (22) présent dans l'élément de batterie (1).

**7.** Procédé selon l'une quelconque des revendications précédentes, dans lequel une mesure du paramètre pendant l'étape a), b) et c) est réalisée dans une chambre de pression fermée (15).

**8.** Procédé selon l'une quelconque des revendications précédentes, dans lequel, pour la détermination de la quantité de matière, au moins une courbe de pression temporelle de la pression environnante, une courbe de température du fluide non conducteur (3) ou une courbe de la force de flottaison sont détectées en continu.

**9.** Procédé selon l'une quelconque des revendications précédentes, dans lequel l'élément de batterie (1) comporte un élément modifié, dont les poches de gaz (2) sont renflées et dans lesquelles la pression interne de gaz (20) est supérieure à une pression de l'air hydrostatique et en particulier supérieure à 1 bar.

**10.** Dispositif de détermination de la quantité d'un gaz (21) se trouvant dans un élément de batterie (1) avec respectivement au moins une chambre de pression (15), un récipient de fluide (4) disposé dans la chambre de pression (15), un dispositif de mesure de pression (8) pour la mesure de la pression environnante (19), un dispositif de génération de force (14) pour générer une force de levage, un dispositif de mesure de force (6) pour mesurer une force de flottaison résultante, ainsi qu'un dispositif de commande (17) pour déterminer et traiter les valeurs de mesure détectées et pour déterminer la quantité du gaz (21).

11. Dispositif selon la revendication précédente, **caractérisé en ce que** celui-ci comporte un dispositif de chauffage (10) pour le chauffage du fluide (3) non conducteur se trouvant dans le récipient de fluide (4) et un dispositif de mesure de température (9) pour mesurer une température de fluide du fluide non conducteur (3).

12. Programme informatique, comprenant des instructions qui entraînent que le dispositif selon la revendication 10 met en œuvre les étapes de procédé selon la revendication 1.

13. Support lisible par ordinateur, sur lequel est stocké le programme informatique selon la revendication 11.

**Fig. 1**

**Fig. 2**

**EP 3 940 864 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20190280333 A1
- KR 20180135587